(19) Europäisches Patentamt
European Patent Office
Office européen des brevets

(11) **EP 4 484 979 B1**

(12) **EUROPEAN PATENT SPECIFICATION**

(45) Date of publication and mention
of the grant of the patent:
**31.12.2025 Bulletin 2026/01**

(21) Application number: **24185024.7**

(22) Date of filing: **27.06.2024**

(51) International Patent Classification (IPC):
*G01R 31/36* (2020.01)          *G01R 31/367* (2019.01)
*G01R 31/382* (2019.01)

(52) Cooperative Patent Classification (CPC):
**G01R 31/367; G01R 31/36; G01R 31/382;**
**Y02E 60/10**

(54) **BATTERY DETECTION METHOD, APPARATUS, AND DEVICE, AND STORAGE MEDIUM**

VERFAHREN,GERÄT,VORRICHTUNG UND SPEICHERMEDIUM ZUR BATTERIEDETEKTION

PROCÉDÉ, APPAREIL, DISPOSITIF ET SUPPORT DE STOCKAGE DE DÉTECTION D'UNE
BATTERIE

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(30) Priority: **29.06.2023 CN 202310786385**

(43) Date of publication of application:
**01.01.2025 Bulletin 2025/01**

(73) Proprietors:
• **Contemporary Amperex Future Energy Research**
**Institute (Shanghai) Limited**
**Shanghai 201100 (CN)**

• **Contemporary Amperex Technology Co., Limited**
**Ningde, Fujian 352100 (CN)**

(72) Inventor: **JIN, Qiujin**
**Shanghai, 201100 (CN)**

(74) Representative: **Gong, Jinping**
**CocreateIP**
**Neumarkter Straße 21**
**81673 München (DE)**

(56) References cited:
**CN-A- 112 881 928      CN-A- 114 879 054**
**CN-A- 115 808 632**

## Description

### TECHNICAL FIELD

This application relates to the field of battery technologies, and specifically, to a battery detection method, apparatus, and device, and a storage medium.

### BACKGROUND

Generally, to implement consistency detection of battery packs, it is necessary to separately calculate the capacity/self-discharge of each battery cell. However, it is unable to record a significant amount of historical data in a BMS battery management system for capacity/self-discharge calculation. It is easier to implement the calculation in the cloud, but obtaining accurate cumulative capacity data in the cloud is often challenging, and more accurate consistency detection of battery packs cannot be implemented.

The document CN 115 808 632 A discloses a method for detecting the consistency of a battery by using simple linear regression between current consistency results and historical data in order to provide more accurate battery consistency results.

### SUMMARY

In view of the foregoing problems, this application provides a battery detection method, apparatus, and device, and a storage medium, so as to address the issue that consistency detection cannot be performed for battery packs more accurately.

According to a first aspect, this application provides a battery cell detection method including:

acquiring state of charge values of each battery cell in a battery system at different time points within a preset time;
selecting a reference battery cell from the battery cells; and
performing multiple linear regression analysis based on state of charge values of the reference battery cell, the state of charge values of each battery cell, and timestamps at corresponding time points to obtain a consistency detection result of the battery cells in the battery system.

In technical solutions of embodiments of this application, a consistency detection result of the battery cells in the battery system is achieved by just selecting a reference battery cell from the battery cells and comparing the reference battery cell with the battery cells, without using accurate cumulative capacity data, obtaining a variation in the state of charge values based on the cumulative capacity data and obtaining the consistency detection result of the battery cells based on the variation in the state of charge values. Even without the capacity data, a relative result can be obtained through calculation, thus consistency of the battery cells is calculated, and the accuracy of battery detection is improved.

In some embodiments, the performing multiple linear regression analysis based on state of charge values of the reference battery cell, the state of charge values of each battery cell, and timestamps at corresponding time points to obtain a consistency detection result of the battery cells in the battery system includes:

acquiring a first matrix established based on state of charge values of the reference battery cell, and acquiring a second matrix established based on the state of charge values of each battery cell and timestamps at corresponding time points;
performing linear regression calculations based on the first matrix and the second matrix to obtain corresponding relative battery capacity and relative self-discharge of each battery cell; and
obtaining a consistency detection result of the battery cells in the battery system based on the corresponding relative battery capacity and relative self-discharge of each battery cell.

In the technical solution of these embodiments of this application, the corresponding relative battery capacity and relative self-discharge of each battery cell are obtained based on the state of charge values of the reference battery cell, the state of charge values of each battery cell, and the timestamps at the corresponding time points. In this way, the corresponding relative battery capacity and relative self-discharge of each battery cell are obtained using the characteristic that the battery cells in the battery system have the same discharge capacity, without using accurate cumulative capacity data, and thus the accuracy of battery detection is improved.

In some embodiments, the performing linear regression calculations based on the first matrix and the second matrix to obtain corresponding relative battery capacity and relative self-discharge of each battery cell further includes:

performing linear regression calculations based on the first matrix and the second matrix to obtain a regression result including a first regression coefficient and a second regression coefficient; and

using the first regression coefficient as a corresponding relative battery capacity of each battery cell and using the second regression coefficient as a corresponding relative self-discharge of each battery cell based on the regression result.

In the technical solution of these embodiments of this application, the corresponding relative battery capacity and relative self-discharge of each battery cell are obtained based on the statistically calculated positive correlation between the corresponding relative battery capacity and relative self-discharge of each battery cell and the state of charge values of the reference battery cell, the state of charge values of each battery cell, and the timestamps at the corresponding time points, without using accurate cumulative capacity data, and thus the efficiency of battery detection is improved.

In some embodiments, the performing linear regression calculations based on the first matrix and the second matrix to obtain a regression result including a first regression coefficient and a second regression coefficient includes:

establishing a linear regression model, where the linear regression model includes a correspondence between a first regression coefficient, a second regression coefficient, the state of charge values of the reference battery cell, the state of charge values of each battery cell, and the timestamps at the corresponding time points; and

substituting the first matrix and the second matrix into the linear regression model for linear calculation to obtain the first regression coefficient and the second regression coefficient.

In the technical solution of these embodiments of this application, the corresponding relative battery capacity and relative self-discharge of each battery cell, the state of charge values of the reference battery cell, the state of charge values of each battery cell, and the timestamps at the corresponding time points are used as known parameters for solving the linear regression model to obtain the regression coefficients. Compared with a conventional calculation method, the method of this application improves the accuracy of calculation.

In some embodiments, the obtaining a positive correlation between the corresponding relative battery capacity and relative self-discharge of each battery cell and the state of charge values of the reference battery cell, the state of charge values of each battery cell, and the timestamps at the corresponding time points includes:

acquiring a first relational expression reflecting a capacity variation of the reference battery cell and acquiring a second relational expression reflecting a capacity variation of each battery cell; and

obtaining, based on the first relational expression and the second relational expression, a positive correlation between the corresponding relative battery capacity and relative self-discharge of each battery cell and the state of charge values of the reference battery cell, the state of charge values of each battery cell, and the timestamps at the corresponding time points.

In the technical solution of these embodiments of this application, the positive correlation between the corresponding relative battery capacity and relative self-discharge of each battery cell and the state of charge values of the reference battery cell, the state of charge values of each battery cell, and the timestamps at the corresponding time points is obtained based on the first relational expression reflecting the capacity variation of the reference battery cell and the second relational expression reflecting the capacity variation of each battery cell, so that the relative battery capacity and relative self-discharge can be obtained more conveniently and simply based on the charge of state values of the reference battery cell, the charge of state of charge values of each battery cell, and the timestamps at the corresponding time points, thereby improving the efficiency of battery detection.

In some embodiments, the obtaining, based on the first relational expression and the second relational expression, a positive correlation between the corresponding relative battery capacity and relative self-discharge of each battery cell and the state of charge values of the reference battery cell, the state of charge values of each battery cell, and the timestamps at the corresponding time points includes:

performing parameter transformation on the first relational expression and the second relational expression under a condition that the first relational expression is equal to the second relational expression; and

obtaining, based on a transformation result, a positive correlation between the corresponding relative battery capacity and relative self-discharge of each battery cell and the state of charge values of the reference battery cell, the state of charge values of each battery cell, and the timestamps at the corresponding time points.

In the technical solution of these embodiments of this application, the positive correlation between the corresponding relative battery capacity and relative self-discharge of each battery cell and the state of charge values of the reference battery cell, the state of charge values of each battery cell, and the timestamps at the corresponding time points is obtained using the characteristic that the battery cells in the battery system have the same discharge capacity, so that more accurate relative battery capacity and relative self-discharge can be further obtained.

In some embodiments, the acquiring a first relational expression reflecting a capacity variation of the reference battery cell and acquiring a second relational expression reflecting a capacity variation of each battery cell includes:

obtaining, based on a battery capacity of the reference battery cell, a charge variation of the reference battery cell, self-discharge of the reference battery cell, and standing time of the reference battery cell, a first relational expression reflecting a capacity variation of the reference battery cell; and

obtaining, based on the battery capacity of each battery cell, a charge variation of each battery cell, self-discharge of each battery cell, and standing time of each battery cell, a second relational expression reflecting a capacity variation of each battery cell.

In the technical solution of these embodiments of this application, a parameter relationship between the corresponding relative battery capacity and relative self-discharge of each battery cell in the linear regression model is obtained based on the established first relational expression and second relational expression, and the relative battery capacity and relative self-discharge can be directly obtained according to the parameter relationship, so that battery detection is implemented based on the reference battery cell, and the accuracy of battery detection is improved.

In some embodiments, the obtaining a consistency detection result of the battery cells in the battery system includes:

obtaining, based on the corresponding relative battery capacity and relative self-discharge of each battery cell, a variation in the battery capacity of each battery cell and the battery capacity of the reference battery cell in the battery system; and

obtaining a consistency detection result of the battery cells in the battery system based on the variation.

In the technical solution of these embodiments of this application, consistency detection of the battery is implemented based on the variation in the battery capacity of each battery cell and the battery capacity of the reference battery cell, and the accuracy of battery detection is improved.

In some embodiments, the obtaining, based on the corresponding relative battery capacity and relative self-discharge of each battery cell, a variation in the battery capacity of each battery cell and the battery capacity of the reference battery cell in the battery system includes:

substituting the corresponding relative battery capacity and relative self-discharge of each battery cell with the regression result to obtain a correspondence between the first matrix and the second matrix;

obtaining, based on the correspondence between the first matrix and the second matrix, a target correspondence between the state of charge values of the battery cells and the state of charge values of the reference battery cell in the battery system; and

obtaining, based on the target correspondence, a variation in the battery capacity of each battery cell and the battery capacity of the reference battery cell in the battery system.

In the technical solution of these embodiments of this application, the state of charge values of the battery cells and the state of charge values of the reference battery cell in the battery system are retrodicted in the regression result based on the corresponding relative battery capacity and relative self-discharge of each battery cell, so that the variation in the battery capacity of each battery cell and the battery capacity of the reference battery cell is obtained, thereby implementing consistency detection of the battery and improving the accuracy of battery detection.

In some embodiments, the obtaining, based on the target correspondence, a variation in the battery capacity of each battery cell and the battery capacity of the reference battery cell in the battery system includes:

under a condition that the state of charge values of each battery cell in the battery system are first state of charge values, obtaining corresponding first reference state of charge values of the reference battery cell based on the target correspondence;

under a condition that the state of charge values of each battery cell in the battery system are second state of charge values, obtaining corresponding second reference state of charge values of the reference battery cell based on the correspondence, where the second state of charge value is less than the first state of charge value; and

using a difference value between the first reference state of charge value and the second reference state of charge value as a variation in the battery capacity of each battery cell and the battery capacity of the reference battery cell.

In the technical solution of these embodiments of this application, the variation in the battery capacity of each battery cell and the battery capacity of the reference battery cell is obtained based on the correspondence between the state of charge values of each battery cell and the state of charge values of the reference battery cell, so that consistency detection of the battery is implemented and the accuracy of battery detection is improved.

In some embodiments, the battery detection method further includes:

providing a warning under a condition that the corresponding relative battery capacity, relative self-discharge, and variation of each battery cell satisfy a preset warning condition.

In the technical solution of these embodiments of this application, under a condition that the preset warning condition is satisfied, warning is performed, so that the use safety of the battery is improved.

In some embodiments, the preset warning condition includes at least one of the following:

the corresponding relative battery capacity of each battery cell is less than a relative battery capacity threshold;
a capacity decrease speed of the corresponding relative battery capacity of each battery cell is greater than a decrease speed threshold within a relative battery capacity monitoring time;
the corresponding relative self-discharge of each battery cell is greater than a relative self-discharge threshold;
a self-discharge increase speed of the corresponding relative self-discharge of each battery cell is greater than an increase speed threshold within a relative self-discharge monitoring time; and
the variation in the battery capacity of each battery cell and the battery capacity of the reference battery cell in the battery system is greater than a variation threshold.

In the technical solution of these embodiments of this application, under a condition that the preset warning condition is satisfied, a warning is provided based on threshold comparison from multiple perspectives, so that effectiveness of battery detection is improved.

According to a second aspect, this application provides a battery cell detection apparatus, where the battery cell detection apparatus includes:

an acquiring module, configured to acquire state of charge values of each battery cell in a battery system at different time points within a preset time;
a selecting module, configured to select a reference battery cell from the battery cells; and
a regression analysis module, configured to perform multiple linear regression analysis based on state of charge values of the reference battery cell, the state of charge values of each battery cell, and timestamps at corresponding time points to obtain a consistency detection result of the battery cells in the battery system.

In technical solutions of embodiments of this application, a consistency detection result of the battery cells in the battery system is achieved by just selecting a reference battery cell from the battery cells and comparing the reference battery cell with the battery cells, without using accurate cumulative capacity data, obtaining a variation in the state of charge values based on the cumulative capacity data and obtaining the consistency detection result of the battery cells based on the variation in the state of charge values. Even without the capacity data, a relative result can be obtained through calculation, thus consistency of the battery cells is calculated, and the accuracy of battery detection is improved.

According to a third aspect, this application provides a battery cell detection device. The battery cell detection device includes a memory, a processor, and a battery detection program stored in the memory and capable of running on the processor, where the battery detection program is configured to implement the battery detection method as described above.

According to a fourth aspect, this application provides a storage medium, where a battery detection program is stored in the storage medium, and when the battery detection program is executed by a processor, the battery detection method as described above is implemented.

The foregoing descriptions are merely an overview of the technical solution of this application. For a better understanding of the technical means in this application such that they can be implemented according to the content of the specification, and to make the above and other objectives, features and advantages of this application more obvious and easier to understand, the following describes specific embodiments of this application.

## BRIEF DESCRIPTION OF DRAWINGS

FIG. 1 is a flowchart of a battery cell detection method according to some embodiments of this application;
FIG. 2 is a flowchart of a battery cell detection method according to some other embodiments of this application;
FIG. 3 is an overall schematic flowchart of a battery cell detection method according to some embodiments of this application; and

FIG. 4 is a schematic structural diagram of a battery cell detection apparatus according to some embodiments of this application.

**DESCRIPTION OF EMBODIMENTS**

The following describes in detail the embodiments of technical solutions of this application with reference to the accompanying drawings. The following embodiments are merely intended for a clearer description of the technical solutions of this application and therefore are merely used as examples which do not constitute any limitation on the protection scope of this application.

Unless otherwise defined, all technical and scientific terms used herein shall have the same meanings as commonly understood by persons skilled in the art to which this application pertains. The terms used herein are intended to merely describe the specific embodiments rather than to limit this application. The terms "include", "comprise", and any other variations thereof in the specification, claims and brief description of drawings of this application are intended to cover non-exclusive inclusions.

In the descriptions of the embodiments of this application, the technical terms "first", "second", and the like are merely intended to distinguish between different objects, and shall not be understood as any indication or implication of relative importance or any implicit indication of the number, specific sequence, or primary-secondary relationship of the technical features indicated. In the descriptions of the embodiments of this application, "multiple" means more than two, unless otherwise specifically defined.

In this specification, reference to "embodiment" means that specific features, structures or characteristics described with reference to the embodiment may be incorporated in at least one embodiment of this application. The word "embodiment" appearing in various places in the specification does not necessarily refer to the same embodiment or an independent or alternative embodiment that is exclusive of other embodiments. It is explicitly or implicitly understood by persons skilled in the art the embodiments described herein may be combined with other embodiments.

In the description of the embodiments of this application, the term "and/or" is only an associative relationship for describing associated objects, indicating that three relationships may be present. For example, A and/or B may indicate the following three cases: presence of only A, presence of both A and B, and presence of only B. In addition, the character "/" in this specification generally indicates an "or" relationship between the contextually associated objects.

In the descriptions of the embodiments of this application, the term "multiple" means more than two (inclusive). Similarly, "multiple groups" means more than two (inclusive) groups, and "multiple pieces" means more than two (inclusive) pieces.

In the description of the embodiments of this application, the orientations or positional relationships indicated by the technical terms "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", " radial", "circumferential", and the like are based on the orientations or positional relationships as shown in the accompanying drawings. These terms are merely for ease and brevity of description of the embodiments of this application rather than indicating or implying that the means or components mentioned must have specific orientations or must be constructed or manipulated according to specific orientations, and therefore shall not be construed as any limitation on the embodiments of this application.

In the description of the embodiments of this application, unless otherwise specified and defined explicitly, the terms "mounting", "connection", "join", and "fastening" should be understood in their general senses. For example, they may refer to a fixed connection, a detachable connection, or an integral connection, may refer to a mechanical connection or electrical connection, and may refer to a direct connection, an indirect connection via an intermediate medium, an internal communication between two elements, or an interaction between two elements. Persons of ordinary skill in the art can understand specific meanings of these terms in the embodiments of this application as appropriate to specific situations. The specific embodiments described herein are merely intended to explain the present invention rather than limit the present invention.

Generally, to implement consistency detection of battery packs, it is necessary to separately calculate the capacity/self-discharge of each battery cell. However, it is unable to record a significant amount of historical data in a BMS battery management system for capacity/self-discharge calculation. It is easier to implement the calculation in cloud, but obtaining accurate cumulative capacity data in cloud is often challenging. Therefore, more accurate consistency detection of battery packs cannot be performed.

To resolve the existing problem that more accurate consistency detection of battery packs cannot be performed, in the embodiments of this application, a consistency detection result of the battery cells in the battery system is achieved by just selecting a reference battery cell from the battery cells and comparing the reference battery cell with the battery cells, without using accurate cumulative capacity data, obtaining a variation in the state of charge values based on the cumulative capacity data and obtaining the consistency detection result of the battery cells based on the variation in the state of charge values. Even without the capacity data, a relative result can be obtained through calculation, thus consistency of the battery cells is calculated, and the accuracy of battery detection is improved.

The battery cell disclosed in the embodiments of this application may be used for electric apparatuses that use a battery as a power source or various energy storage systems that use a battery as an energy storage element. The electric apparatus may be but is not limited to a mobile phone, a tablet computer, a laptop computer, an electric toy, an electric tool, an electric bicycle, an electric vehicle, a ship, and a spacecraft. The electric toy may be a fixed or mobile electric toy, for example, a game console, an electric toy car, an electric toy ship, and an electric toy airplane. The spacecraft may include an airplane, a rocket, a space shuttle, a spaceship, and the like.

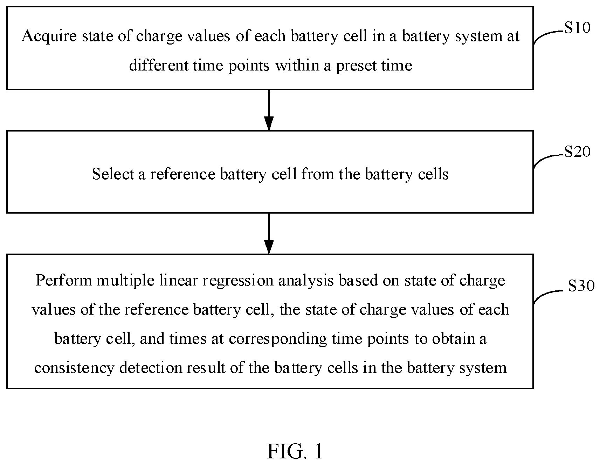

To resolve the existing problem that more accurate consistency detection of battery packs cannot be performed, this application proposes a battery detection method. Referring to FIG. 1, in the example, the battery detection method includes the following steps.

Step S10. Acquire state of charge values of each battery cell in a battery system at different time points within a preset time.

It should be noted that this embodiment may be executed by a controller in the battery system or another service processor, and this is not limited in this embodiment. In this embodiment, the controller in the battery system is used as an example for description, where the preset time may be 1 day or 1 hour, and this is not limited in this embodiment. In an example in which the preset time is 1 day, the state of charge values of each battery cell in the battery system at different time points within the preset time are acquired, that is, SOC values, to provide data support for subsequent linear calculation. Generally, state of charge values are usually obtained through calculation based on an open circuit voltage of a battery after standing.

In a specific implementation, a sensor is used to acquire data such as current, voltage, and temperature of the battery. The sensor is connected to the controller in the battery system and transmits the acquired data such as current, voltage, and temperature of the battery to the controller in the battery system. After obtaining the data such as current, voltage, and temperature of the battery, the controller screens the data such as current, voltage, and temperature of the battery to obtain data satisfying a condition of the open circuit voltage, that is, open circuit voltage data of the battery after a certain time of full standing. In this way, the detection accuracy is improved. The controller in the battery system obtains state of charge values at different time points based on the open circuit voltage of the battery after standing that is acquired by the sensor, thereby implementing automatic data acquisition.

Step S20. Select a reference battery cell from the battery cells.

In this embodiment, the reference battery cell may be one battery cell selected from the battery cells in the battery system. The reference battery cell may be selected randomly or selected in a default manner. Alternatively, an average value of the battery may be used as a virtual reference battery. This is not limited in this embodiment. One reference battery cell is selected using the characteristic that the battery cells in the battery system have the same discharge capacity, a battery capacity variation ∆Ah of the reference battery cell is used to replace ∆Ah of all the other battery cells, so that consistency detection of the battery can be implemented without capacity information, avoiding errors in detection results caused by miscalculation of the capacity information, thereby improving the accuracy of battery detection.

Step S30. Perform multiple linear regression analysis based on state of charge values of the reference battery cell, the state of charge values of each battery cell, and timestamps at corresponding time points to obtain a consistency detection result of the battery cells in the battery system.

It should be noted that the state of charge values of the reference battery cell are represented by $SOC_{ref}$, the state of charge values of each battery cell are represented by $SOC_n$, and the timestamps at corresponding time points is represented by *Time* , where $SOC_{ref}$, $SOC_n$, and *Time* are used for multiple linear regression analysis, and consistency detection of the battery cells in the battery system can be implemented without ∆Ah and state of charge value variation ∆SOC.

Generally, battery capacity, self-discharge, and state of equilibrium are important characteristic parameters of battery packs. The consistency of a battery system is measured based on the battery capacity, self-discharge, and state of equilibrium. In consistency detection of battery cells, capacity differences of the battery cells in the battery system are detected. In this embodiment, consistency detection of the battery cells is implemented using the reference battery cell. Therefore, multiple linear regression analysis is performed based on the state of charge values of the reference battery cell, the state of charge values of each battery cell, and timestamps at corresponding time points to obtain the relative battery capacity and relative self-discharge of each battery cell, and consistency detection of the battery cells is implemented based on the relative battery capacity and relative self-discharge of each battery cell, so that the original consistency detection manner of the battery is changed, and the consistency detection of the battery is performed in a totally new manner. In this way, the consistency detection of the battery can be implemented without capacity information, avoiding errors in detection results caused by miscalculation of the capacity information, thereby improving the accuracy of battery detection.

In technical solutions of embodiments of this application, a consistency detection result of the battery cells in the battery system is achieved by just selecting a reference battery cell from the battery cells and comparing the reference battery cell with the battery cells, without using accurate cumulative capacity data, obtaining a variation in the state of charge values based on the cumulative capacity data and obtaining the consistency detection result of the battery cells based on the variation in the state of charge values. Even without the capacity data, a relative result can be obtained through calculation, thus consistency of the battery cells is calculated, and the accuracy of battery detection is improved.

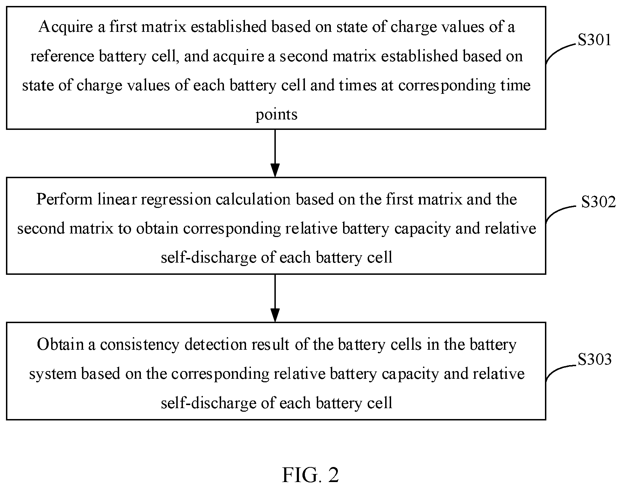

A second embodiment of the present invention is proposed based on the first embodiment. In the second embodiment, as shown in FIG. 2, step S30 includes the following steps.

Step S301. Acquire a first matrix established based on state of charge values of the reference battery cell, and acquire a second matrix established based on the state of charge values of each battery cell and timestamps at corresponding time points.

Step S302. Perform linear regression calculations based on the first matrix and the second matrix to obtain corresponding relative battery capacity and relative self-discharge of each battery cell.

Step S303. Obtain a consistency detection result of the battery cells in the battery system based on the corresponding relative battery capacity and relative self-discharge of each battery cell.

It should be noted that the first matrix Y established based on the state of charge values of the reference battery cell is:

$$Y = \begin{bmatrix} SOC_{ref\,1} \\ SOC_{ref\,2} \\ \vdots \\ SOC_{ref\,t} \end{bmatrix};$$

where $SOC_{ref\,t}$ represents the state of charge values of the reference battery cell at 1-t time points, respectively.

The second matrix X established based on the state of charge values of each battery cell and timestamps at corresponding time points is:

$$X = \begin{bmatrix} 1 & SOC_{n1} & \text{Time}_1 \\ 1 & SOC_{n2} & \text{Time}_2 \\ \vdots & \vdots & \vdots \\ 1 & SOC_{nt} & \text{Time}_t \end{bmatrix};$$

where $SOC_{nt}$ represents the state of charge values of a battery cell whose number is n in the battery system at 1-t time points, and *Time,* represents the timestamps corresponding to the 1-t time points of each battery cell.

In a specific implementation, data at different time points within a certain time window, including time and the selected reference battery cell, are collected to obtain X and Y that are inputted into matrices (for example, there are t pieces of data), and linear regression calculations are performed based on the first matrix and the second matrix to obtain corresponding relative battery capacity and relative self-discharge of each battery cell.

Linear regression calculations are performed to obtain a result:

$$\beta = (X^T X)^{-1} X^T Y = \begin{bmatrix} \beta_1 \\ \beta_2 \\ \beta_3 \end{bmatrix} \quad \text{Formula 1;}$$

where $\beta_1$ represents an intercept, $\beta_2$ represents a relative capacity of each battery cell, and $\beta_3$ represents a relative self-discharge of each battery cell.

Relative capacity: $\dfrac{CAP_n}{CAP_{ref}} = \beta_2$ ; and

relative self-discharge:

$$\frac{SlfDch_n - SlfDch_{ref}}{CAP_{ref}} = \beta_3 \ ;$$

where $CAP_n$ represents the capacity of each battery cell, $CAP_{ref}$ represents the capacity of the reference battery cell, $slfDch_n$ represents the self-discharge of each battery cell, and $slfDch_{ref}$ represents the self-discharge of the reference battery cell.

In this embodiment, the corresponding relative battery capacity and relative self-discharge of each battery cell are obtained based on the state of charge values of the reference battery cell, the state of charge values of each battery cell, and the timestamps at the corresponding time points. In this way, the corresponding relative battery capacity and relative self-discharge of each battery cell are obtained using the characteristic that the battery cells in the battery system have the same discharge capacity, without using accurate cumulative capacity data, and thus the accuracy of battery detection is improved.

According to some embodiments of this application, optionally, step S302 includes:

performing linear regression calculations based on the first matrix and the second matrix to obtain a regression result including a first regression coefficient and a second regression coefficient; and
using the first regression coefficient as a corresponding relative battery capacity of each battery cell and using the second regression coefficient as a corresponding relative self-discharge of each battery cell based on the regression result.

It should be noted that the first regression coefficient is $\beta_2$, and the second regression coefficient is $\beta_3$. In an established linear relationship between the first matrix and the second matrix, known input parameters are $SOC_{ref,t}$, $SOC_{n,t}$, and $Time_t$, and a linear model related to $SOC_{ref,t}$, $SOC_{n,t}$, and $Time$, is obtained based on linear calculation.

Under a condition that a positive correlation between the corresponding relative battery capacity and relative self-discharge of each battery cell and the state of charge values of the reference battery cell, the state of charge values of each battery cell, and the timestamps at the corresponding time points is statistically calculated, the correlation thereof is:

$$SOC_{ref} = \frac{CAP_n}{CAP_{ref}} \times SOC_n + \frac{slfDch_n - slfDch_{ref}}{CAP_{ref}} \times time + Intercept \qquad \text{Formula 2;}$$

where Intercept represents an intercept.

A relationship between $\dfrac{CAP_n}{CAP_{ref}}$, $\dfrac{slfDch_n - slfDch_{ref}}{CAP_{ref}}$, $SOC_{ref}$, $SOC_n$, and $Time$ is obtained based on the positive correlation, so that a correspondence between regression coefficients obtained by solving Formula 1 and coefficients formed by $\dfrac{CAP_n}{CAP_{ref}}$ and $\dfrac{slfDch_n - slfDch_{ref}}{CAP_{ref}}$ Formula 2 can be obtained.

It can be seen that the following can be obtained:

$$\frac{CAP_n}{CAP_{ref}} = \beta_2 ;$$

and

$$\frac{SlfDch_n - SlfDch_{ref}}{CAP_{ref}} = \beta_3 \ ;$$

where $\beta_2$ represents a relative capacity of each battery cell, and $\beta_3$ represents a relative self-discharge of each battery cell.

In the technical solution of these embodiments of this application, the corresponding relative battery capacity and relative self-discharge of each battery cell are obtained based on the statistically calculated positive correlation between the corresponding relative battery capacity and relative self-discharge of each battery cell and the state of charge values of the reference battery cell, the state of charge values of each battery cell, and the timestamps at the corresponding time points, without using accurate cumulative capacity data, and thus the efficiency of battery detection is improved.

According to some embodiments of this application, optionally, the performing linear regression calculations based on the first matrix and the second matrix to obtain a regression result including a first regression coefficient and a second regression coefficient includes:

establishing a linear regression model, where the linear regression model includes a correspondence between a first regression coefficient, a second regression coefficient, the state of charge values of the reference battery cell, the state of charge values of each battery cell, and the timestamps at the corresponding time points; and
substituting the first matrix and the second matrix into the linear regression model for linear calculation to obtain the first regression coefficient and the second regression coefficient.

In these embodiments, the linear regression model is denoted as Formula 1, and Formula 1 can be solved to obtain the first regression coefficient and the second regression coefficient, so as to obtain the corresponding relative battery capacity and relative self-discharge of each battery cell, without using accurate cumulative capacity data. In this way, the calculation accuracy is improved.

According to some embodiments of this application, optionally, the obtaining a positive correlation between the corresponding relative battery capacity and relative self-discharge of each battery cell and the state of charge values of the reference battery cell, the state of charge values of each battery cell, and the timestamps at the corresponding time points includes:

acquiring a first relational expression reflecting a capacity variation of the reference battery cell and acquiring a second relational expression reflecting a capacity variation of each battery cell; and
obtaining, based on the first relational expression and the second relational expression, a positive correlation between the corresponding relative battery capacity and relative self-discharge of each battery cell and the state of charge values of the reference battery cell, the state of charge values of each battery cell, and the timestamps at the corresponding time points.

The first relational expression is:

$$CAP_{ref} \times \Delta SOC_{ref} + slfDch_{ref} \times time \quad \text{Formula 3}.$$

The second relational expression is:

$$CAP_n \times \Delta SOC_n + slfDch_n \times time + Intercept \quad \text{Formula 4}.$$

In these embodiments, the positive correlation between the corresponding relative battery capacity and relative self-discharge of each battery cell and the state of charge values of the reference battery cell, the state of charge values of each battery cell, and the timestamps at the corresponding time points is obtained based on the first relational expression reflecting the capacity variation of the reference battery cell and the second relational expression reflecting the capacity variation of each battery cell, so that the relative battery capacity and relative self-discharge can be obtained more conveniently and simply based on the charge of state values of the reference battery cell, the charge of state of charge values of each battery cell, and the timestamps at the corresponding time points, thereby improving the efficiency of battery detection.

According to some embodiments of this application, optionally, the obtaining, based on the first relational expression and the second relational expression, a positive correlation between the corresponding relative battery capacity and relative self-discharge of each battery cell and the state of charge values of the reference battery cell, the state of charge values of each battery cell, and the timestamps at the corresponding time points includes:

performing parameter transformation on the first relational expression and the second relational expression under a condition that the first relational expression is equal to the second relational expression; and
obtaining, based on a transformation result, a positive correlation between the corresponding relative battery capacity and relative self-discharge of each battery cell and the state of charge values of the reference battery cell, the state of charge values of each battery cell, and the timestamps at the corresponding time points.

In a specific implementation, the battery cells in the battery system have the same discharge capacity. Therefore, the first relational expression is equal to the second relational expression. To be specific, the following is obtained based on Formula 3 and Formula 4:

$$CAP_{ref} \times \Delta SOC_{ref} + slfDch_{ref} \times time = CAP_n \times \Delta SOC_n + slfDch_n \times time + Intercept$$

Formula 5.

The following is obtained through transformation:

$$SOC_{ref} = \frac{CAP_n}{CAP_{ref}} \times SOC_n + \frac{slfDch_n - slfDch_{ref}}{CAP_{ref}} \times time + Intercept$$

In this way, a positive correlation between $SOC_{ref}$, $SOC_n$, $Time_t$, $\dfrac{CAP_n}{CAP_{ref}}$, and $\dfrac{slfDch_n - slfDch_{ref}}{CAP_{ref}}$ is obtained.

In this application, the positive correlation between the corresponding relative battery capacity and relative self-discharge of each battery cell and the state of charge values of the reference battery cell, the state of charge values of each battery cell, and the timestamps at the corresponding time points is obtained using the characteristic that the battery cells in the battery system have the same discharge capacity, so that more accurate relative battery capacity and relative self-discharge can be further obtained.

According to some embodiments of this application, optionally, the acquiring a first relational expression reflecting a capacity variation of the reference battery cell and acquiring a second relational expression reflecting a capacity variation of each battery cell includes:

> obtaining, based on a battery capacity of the reference battery cell, a charge variation of the reference battery cell, self-discharge of the reference battery cell, and standing time of the reference battery cell, a first relational expression reflecting a capacity variation of the reference battery cell; and
> obtaining, based on the battery capacity of each battery cell, a charge variation of each battery cell, self-discharge of each battery cell, and standing time of each battery cell, a second relational expression reflecting a capacity variation of each battery cell.

The first relational expression is:

$$CAP_{ref} \times \Delta SOC_{ref} + slfDch_{ref} \times time$$

The second relational expression is:

$$CAP_n \times \Delta SOC_n + slfDch_n \times time + Intercep$$

In these embodiments, a parameter relationship between the corresponding relative battery capacity and relative self-discharge of each battery cell in the linear regression model is obtained based on the established first relational expression and second relational expression, and the relative battery capacity and relative self-discharge can be directly obtained according to the parameter relationship, so that battery detection is implemented based on the reference battery cell, and the accuracy of battery detection is improved.

According to some embodiments of this application, optionally, the obtaining a consistency detection result of the battery cells in the battery system includes:

> obtaining, based on the corresponding relative battery capacity and relative self-discharge of each battery cell, a variation in the battery capacity of each battery cell and the battery capacity of the reference battery cell in the battery system; and
> obtaining a consistency detection result of the battery cells in the battery system based on the variation.

In these embodiments, the variation in the battery capacity of each battery cell and the battery capacity of the reference battery cell in the battery system is a difference value between the battery capacity of each battery cell and the battery capacity of the reference battery cell in the battery system. Based on the difference value between the battery capacity of each battery cell and the battery capacity of the reference battery cell, capacity differences between the battery cells can be obtained, and thus a consistency detection result of the battery cells in the battery system can be obtained.

According to some embodiments of this application, optionally, the obtaining, based on the corresponding relative battery capacity and relative self-discharge of each battery cell, a variation in the battery capacity of each battery cell and the battery capacity of the reference battery cell in the battery system includes:

substituting a regression result corresponding to the corresponding relative battery capacity and relative self-discharge of each battery cell into a third relational expression to obtain a correspondence between the state of charge values of each battery cell and the state of charge values of the reference battery cell; and obtaining, based on the correspondence, a variation in the battery capacity of each battery cell and the battery capacity of the reference battery cell in the battery system.

The calculated regression result of each battery cell is substituted into Formula 6 to obtain a correspondence between state of charge of each battery and state of charge of the reference battery. A correspondence between the state of charge of each battery and the state of charge of the reference battery in a fully charged state and a fully discharged state respectively, and an available state of charge range in the battery system is calculated based on the correspondence, where a third relational expression is shown in Formula 6.

$$SOC_{ref} = \begin{bmatrix} 1 & SOC_n & Time_{now} \end{bmatrix} \bullet \beta \quad \text{Formula 6;}$$

where $Time_{now}$ represents a current time point.

The variation in the battery capacity of each battery cell and the battery capacity of the reference battery cell can be obtained based on the target correspondence, and a relative relationship between the capacity of the battery system and the capacity of the reference battery is further obtained, thereby implementing detection of the state of equilibrium.

In this application, the state of charge values of the battery cells and the state of charge values of the reference battery cell in the battery system are retrodicted in the regression result based on the corresponding relative battery capacity and relative self-discharge of each battery cell, so that the variation in the battery capacity of each battery cell and the battery capacity of the reference battery cell is obtained, and the relative relationship between the capacity of the battery system and the capacity of the reference battery is further obtained, thereby implementing consistency detection of the battery and improving the accuracy of battery detection.

According to some embodiments of this application, optionally, the obtaining, based on the target correspondence, a variation in the battery capacity of each battery cell and the battery capacity of the reference battery cell in the battery system includes:

under a condition that the state of charge values of each battery cell in the battery system are first state of charge values, obtaining corresponding first reference state of charge values of the reference battery cell based on the target correspondence; under a condition that the state of charge values of each battery cell in the battery system are second state of charge values, obtaining corresponding second reference state of charge values of the reference battery cell based on the correspondence, where the second state of charge value is less than the first state of charge value; and using a difference value between the first reference state of charge value and the second reference state of charge value as a variation in the battery capacity of each battery cell and the battery capacity of the reference battery cell.

In these embodiments, in calculation of the state of equilibrium, for example, m battery cells are provided in the battery system, a relative relationship between an available capacity of the battery system and the capacity of the reference battery cell within a range of 0 to 100% is calculated; at the current time point $Time_{now}$, the first state of charge value is a state of charge value $SOC_{ref\_n\_100\%} == [1\ 100\%\ Time_{now}] \bullet \beta$ of the reference battery cell when $SOC_n$ is 100%, obtained according to Formula 6 under a condition that the state of charge value of each battery cell is 100%, that is, 100% SOC, $SOC_n$ is 100%, and the corresponding relative battery capacity and relative self-discharge of each battery cell is $\beta$; a minimum value of the state of charge values of all the battery cells in the system is $SOC_{ref\_hi} = \min(SOC_{ref\_1\_100\%}, SOC_{ref\_2\_100\%} ... SOC_{ref\_m\_100\%})$ ; and the first reference state of charge value is obtained as $SOC_{ref\_hi}$.

Similarly, the second state of charge value is a state of charge value $SOC_{ref\_n\_0\%} == [1\ 0\ Time_{now}] \bullet \beta$ of the reference battery cell when $SOC_n$ is 0, obtained according to Formula 6 under a condition that the state of charge value of each battery cell is 0, that is, 0SOC, $SOC_n$ is 0SOC, and the corresponding relative battery capacity and relative self-discharge of each battery cell is $\beta$; a maximum value of the state of charge values of all the battery cells in the system is $SOC_{ref\_lo} = \max(SOC_{ref\_1\_0\%}, SOC_{ref\_2\_0\%} ... SOC_{ref\_m\_0\%})$; and the second reference state of charge value is obtained as $SOC_{ref\_lo}$.

Therefore, the available capacity of the battery system decreases with respect to the capacity of the reference battery cell: 100% - $SOC_{ref\_hi}$ + $SOC_{ref\_lo}$, so that the variation in the available capacity of the battery system and the battery capacity of the reference battery cell is obtained.

In this application, the variation in the battery capacity of each battery cell and the battery capacity of the reference battery cell is obtained based on the correspondence between the state of charge values of each battery cell and the state of charge values of the reference battery cell, thereby implementing consistency detection of the battery and improving the accuracy of battery detection.

According to some embodiments of this application, optionally, the battery detection method further includes: providing a warning under a condition that the corresponding relative battery capacity, relative self-discharge, and variation of each battery cell satisfy a preset warning condition.

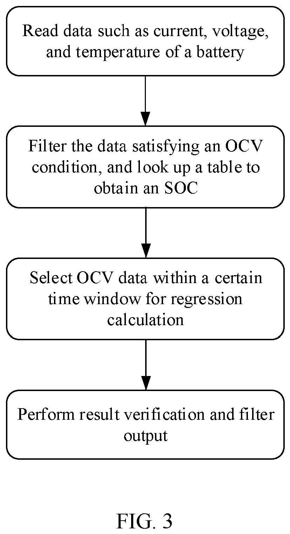

As shown in the overall schematic flowchart in FIG. 3, the following steps are mainly included.

Step 1. Read data such as current, voltage, and temperature of the battery, excluding capacity data.

Step 2. Filter the data satisfying an OCV condition, and consider that the battery satisfies the OCV condition after it undergoes a certain time of full standing.

Step 3. Select multiple pieces of OCV data within a certain time window for regression calculation.

Step 4. Obtain a consistency result of the battery.

Step 5. Provide a capacity consistency warning for a battery whose relative capacity is low or relative capacity decrease speed is too high; provide a self-discharge consistency warning for a battery whose relative self-discharge is high or relative self-discharge increase speed is too high; and calculate the capacity of the battery system based on the capacity of the battery cell.

According to some embodiments of this application, optionally, the preset warning condition includes at least one of the following:

the corresponding relative battery capacity of each battery cell is less than a relative battery capacity threshold;
a capacity decrease speed of the corresponding relative battery capacity of each battery cell is greater than a decrease speed threshold within a relative battery capacity monitoring time;
the corresponding relative self-discharge of each battery cell is greater than a relative self-discharge threshold;
a self-discharge increase speed of the corresponding relative self-discharge of each battery cell is greater than an increase speed threshold within a relative self-discharge monitoring time; and
the variation in the battery capacity of each battery cell and the battery capacity of the reference battery cell in the battery system is greater than a variation threshold.

In this application, under a condition that the preset warning condition is satisfied, a warning is provided based on threshold comparison from multiple perspectives, so that effectiveness of battery detection is improved.

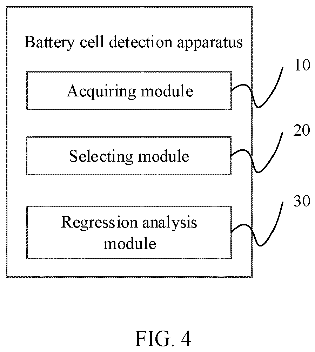

According to some embodiments of this application, referring to FIG. 4, FIG. 4 is a schematic structural diagram of a battery cell detection apparatus according to some embodiments of this application.

In these embodiments, the battery cell detection apparatus includes:

an acquiring module 10, configured to acquire state of charge values of each battery cell in a battery system at different time points within a preset time;
a selecting module 20, configured to select a reference battery cell from the battery cells; and
a regression analysis module 30, configured to perform multiple linear regression analysis based on state of charge values of the reference battery cell, the state of charge values of each battery cell, and timestamps at corresponding time points to obtain a consistency detection result of the battery cells in the battery system.

In this application, a consistency detection result of the battery cells in the battery system is achieved by just selecting the reference battery cell from the battery cells and comparing the reference battery cell with the battery cells, without using cumulative capacity data, obtaining a variation in the state of charge values based on the cumulative capacity data and obtaining the consistency detection result of the battery cells based on the variation in the state of charge values. Even without the capacity data, a relative result can be obtained through calculation, thus consistency of the battery cells is calculated, and the accuracy of battery detection is improved.

In conclusion, it should be noted that the foregoing embodiments are merely for describing the technical solutions of this application rather than for limiting this application. Although this application has been described in detail with reference to the foregoing embodiments, persons of ordinary skill in the art should appreciate that they can still make modifications to the technical solutions described in the embodiments without departing from the scope of the technical solutions of the embodiments of this application. All such modifications shall fall within the scope of claims and specification of this application. In particular, as long as there is no structural conflict, the various technical features mentioned in the embodiments can be combined in any manner. This application is not limited to the specific embodiments disclosed in this specification, but includes all technical solutions falling within the scope of the claims.

**Claims**

1. A battery detection method, **characterized in that** the battery detection method comprises:

   Acquiring (S10) state of charge values of each battery cell in a battery system at different time points within a preset time;
   selecting (S20) a reference battery cell from the battery cells; and
   performing multiple linear regression analysis (S30) based on state of charge values of the reference battery cell, the state of charge values of each battery cell, and timestamps at corresponding time points to obtain a consistency detection result of the battery cells in the battery system.

2. The battery detection method according to claim 1, **characterized in that** the performing multiple linear regression analysis (S30) based on state of charge values of the reference battery cell, the state of charge values of each battery cell, and timestamps at corresponding time points to obtain a consistency detection result of the battery cells in the battery system comprises:

   acquiring (S301) a first matrix established based on state of charge values of the reference battery cell, and acquiring a second matrix established based on the state of charge values of each battery cell and timestamps at corresponding time points;
   performing linear regression calculations (S302) based on the first matrix and the second matrix to obtain corresponding relative battery capacity and relative self-discharge of each battery cell; and
   obtaining (S303) a consistency detection result of the battery cells in the battery system based on the corresponding relative battery capacity and relative self-discharge of each battery cell.

3. The battery detection method according to claim 2, **characterized in that** the performing linear regression calculations (S302) based on the first matrix and the second matrix to obtain corresponding relative battery capacity and relative self-discharge of each battery cell comprises:

   performing linear regression calculations based on the first matrix and the second matrix to obtain a regression result including a first regression coefficient and a second regression coefficient; and
   using the first regression coefficient as a corresponding relative battery capacity of each battery cell and using the second regression coefficient as a corresponding relative self-discharge of each battery cell based on the regression result.

4. The battery detection method according to claim 3, **characterized in that** the performing linear regression calculations based on the first matrix and the second matrix to obtain a regression result comprising a first regression coefficient and a second regression coefficient comprises:

   establishing a linear regression model, where the linear regression model includes a correspondence between a first regression coefficient, a second regression coefficient, the state of charge values of the reference battery cell, the state of charge values of each battery cell, and the timestamps at the corresponding time points; and
   substituting the first matrix and the second matrix into the linear regression model for linear calculation to obtain the first regression coefficient and the second regression coefficient.

5. The battery detection method according to any one of claims 1 to 4, **characterized in that** the battery detection method further comprises:

   acquiring a first relational expression reflecting a capacity variation of the reference battery cell and acquiring a second relational expression reflecting a capacity variation of each battery cell; and
   obtaining, based on the first relational expression and the second relational expression, a positive correlation between the corresponding relative battery capacity and relative self-discharge of each battery cell and the state of charge values of the reference battery cell, the state of charge values of each battery cell, and the timestamps at the corresponding time points.

6. The battery detection method according to claim 5, **characterized in that** the obtaining, based on the first relational expression and the second relational expression, a positive correlation between the corresponding relative battery capacity and relative self-discharge of each battery cell and the state of charge values of the reference battery cell, the state of charge values of each battery cell, and the timestamps at the corresponding time points comprises:

performing parameter transformation on the first relational expression and the second relational expression under a condition that the first relational expression is equal to the second relational expression; and

obtaining, based on a transformation result, a positive correlation between the corresponding relative battery capacity and relative self-discharge of each battery cell and the state of charge values of the reference battery cell, the state of charge values of each battery cell, and the timestamps at the corresponding time points.

7. The battery detection method according to claim 5, **characterized in that** the acquiring a first relational expression reflecting a capacity variation of the reference battery cell and acquiring a second relational expression reflecting a capacity variation of each battery cell comprises:

obtaining, based on a battery capacity of the reference battery cell, a charge variation of the reference battery cell, self-discharge of the reference battery cell, and timestamps at corresponding time points of the reference battery cell, a first relational expression reflecting a capacity variation of the reference battery cell; and

obtaining, based on the battery capacity of each battery cell, a charge variation of each battery cell, self-discharge of each battery cell, and standing time of each battery cell, a second relational expression reflecting a capacity variation of each battery cell.

8. The battery detection method according to claim 3, **characterized in that** the obtaining a consistency detection result of the battery cells in the battery system comprises:

obtaining, based on the corresponding relative battery capacity and relative self-discharge of each battery cell, a variation in the battery capacity of each battery cell and the battery capacity of the reference battery cell in the battery system; and

obtaining a consistency detection result of the battery cells in the battery system based on the variation.

9. The battery detection method according to claim 8, **characterized in that** the obtaining, based on the corresponding relative battery capacity and relative self-discharge of each battery cell, a variation in the battery capacity of each battery cell and the battery capacity of the reference battery cell in the battery system comprises:

substituting a regression result corresponding to the corresponding relative battery capacity and relative self-discharge of each battery cell into a third relational expression to obtain a correspondence between the state of charge values of each battery cell and the state of charge values of the reference battery cell; and

obtaining, based on the correspondence, a variation in the battery capacity of each battery cell and the battery capacity of the reference battery cell in the battery system.

10. The battery detection method according to claim 9, **characterized in that** the obtaining, based on the correspondence, a variation in the battery capacity of each battery cell and the battery capacity of the reference battery cell in the battery system comprises:

under a condition that the state of charge values of each battery cell in the battery system are first state of charge values, obtaining corresponding first reference state of charge values of the reference battery cell based on the correspondence;

under a condition that the state of charge values of each battery cell in the battery system are second state of charge values, obtaining corresponding second reference state of charge values of the reference battery cell based on the correspondence, wherein the second state of charge value is less than the first state of charge value; and

using a difference value between the first reference state of charge value and the second reference state of charge value as a variation in the battery capacity of each battery cell and the battery capacity of the reference battery cell.

11. The battery detection method according to claim 8, **characterized in that** the battery detection method further comprises:

providing a warning under a condition that the corresponding relative battery capacity, relative self-discharge, and variation of each battery cell satisfy a preset warning condition.

12. The battery detection method according to claim 11, **characterized in that** the preset warning condition comprises at least one of the following:

the corresponding relative battery capacity of each battery cell is less than a relative battery capacity threshold;

a capacity decrease speed of the corresponding relative battery capacity of each battery cell is greater than a decrease speed threshold within a relative battery capacity monitoring time;

the corresponding relative self-discharge of each battery cell is greater than a relative self-discharge threshold;

a self-discharge increase speed of the corresponding relative self-discharge of each battery cell is greater than an increase speed threshold within a relative self-discharge monitoring time; and

the variation in the battery capacity of each battery cell and the battery capacity of the reference battery cell in the battery system is greater than a variation threshold.

13. A battery detection apparatus, **characterized in that** the battery detection apparatus comprises:

an acquiring module (10), configured to acquire state of charge values of each battery cell in a battery system at different time points within a preset time;

a selecting module (20), configured to select a reference battery cell from the battery cells; and

a regression analysis module (30), configured to perform multiple linear regression analysis based on state of charge values of the reference battery cell, the state of charge values of each battery cell, and timestamps at corresponding time points to obtain a consistency detection result of the battery cells in the battery system.

14. A battery detection device, **characterized in that** the battery detection device comprises a memory, a processor, and a battery detection program stored in the memory and capable of running on the processor, wherein the battery detection program is configured to implement the battery detection method according to any one of claims 1 to 12.

15. A storage medium, **characterized in that** the storage medium stores a battery detection program, wherein when the battery detection program is executed by a processor, the battery detection method according to any one of claims 1 to 12 is implemented.

**Patentansprüche**

1. Batteriedetektionsverfahren, **dadurch gekennzeichnet, dass** das Batteriedetektionsverfahren Folgendes umfasst:

Erfassen (S10) von Ladungszustandswerten jeder Batteriezelle in einem Batteriesystem zu verschiedenen Zeitpunkten innerhalb einer vorgegebenen Zeitspanne;

Auswählen (S20) einer Referenzbatteriezelle aus den Batteriezellen; und

Durchführen (S30) einer multiplen linearen Regressionsanalyse auf der Grundlage von Ladungszustandswerten der Referenzbatteriezelle, der Ladungszustandswerte jeder Batteriezelle und von Zeitstempeln zu entsprechenden Zeitpunkten, um ein Konsistenzdetektionsergebnis der Batteriezellen im Batteriesystem zu erhalten.

2. Batteriedetektionsverfahren nach Anspruch 1, **dadurch gekennzeichnet, dass** das Durchführen (S30) einer multiplen linearen Regressionsanalyse auf der Grundlage von Ladungszustandswerten der Referenzbatteriezelle, der Ladungszustandswerte jeder Batteriezelle und von Zeitstempeln zu den entsprechenden Zeitpunkten, um ein Konsistenzdetektionsergebnis der Batteriezellen im Batteriesystem zu erhalten, Folgendes umfasst:

Erfassen (S301) einer ersten Matrix, die auf der Grundlage von Ladungszustandswerten der Referenzbatteriezelle erstellt wird, und Erfassen einer zweiten Matrix, die auf der Grundlage der Ladungszustandswerte jeder Batteriezelle und von Zeitstempeln zu den entsprechenden Zeitpunkten erstellt wird;

Durchführen (S302) von Berechnungen zur linearen Regression auf der Grundlage der ersten Matrix und der zweiten Matrix, um eine entsprechende relative Batteriekapazität und relative Selbstentladung jeder Batteriezelle zu erhalten; und

Erhalten (S303) eines Konsistenzdetektionsergebnisses der Batteriezellen im Batteriesystem auf der Grundlage der entsprechenden relativen Batteriekapazität und relativen Selbstentladung jeder Batteriezelle.

3. Batteriedetektionsverfahren nach Anspruch 2, **dadurch gekennzeichnet, dass** das Durchführen (S302) von Berechnungen zur linearen Regression auf der Grundlage der ersten Matrix und der zweiten Matrix, um eine entsprechende relative Batteriekapazität und relative Selbstentladung jeder Batteriezelle zu erhalten, Folgendes umfasst:

Durchführen von Berechnungen zur linearen Regression auf der Grundlage der ersten Matrix und der zweiten Matrix, um ein Regressionsergebnis zu erhalten, das einen ersten Regressionskoeffizienten und einen zweiten Regressionskoeffizienten enthält; und

Verwenden des ersten Regressionskoeffizienten als eine entsprechende relative Batteriekapazität jeder Batteriezelle und Verwenden des zweiten Regressionskoeffizienten als eine entsprechende relative Selbstentladung jeder Batteriezelle auf der Grundlage des Regressionsergebnisses.

4. Batteriedetektionsverfahren nach Anspruch 3, **dadurch gekennzeichnet, dass** das Durchführen von Berechnungen zur linearen Regression auf der Grundlage der ersten Matrix und der zweiten Matrix, um ein Regressionsergebnis zu erhalten, das einen ersten Regressionskoeffizienten und einen zweiten Regressionskoeffizienten umfasst, Folgendes umfasst:

Errichten eines linearen Regressionsmodells, wobei das lineare Regressionsmodell eine Entsprechung zwischen einem ersten Regressionskoeffizienten, einem zweiten Regressionskoeffizienten, den Ladungszustandswerten der Referenzbatteriezelle, den Ladungszustandswerten jeder Batteriezelle und den Zeitstempeln zu den entsprechenden Zeitpunkten enthält; und

Einsetzen der ersten Matrix und der zweiten Matrix in das lineare Regressionsmodell zur linearen Berechnung, um den ersten Regressionskoeffizienten und den zweiten Regressionskoeffizienten zu erhalten.

5. Batteriedetektionsverfahren nach einem der Ansprüche 1 bis 4, **dadurch gekennzeichnet, dass** das Batteriedetektionsverfahren ferner Folgendes umfasst:

Erfassen eines ersten relationalen Ausdrucks, der eine Kapazitätsveränderung der Referenzbatteriezelle wiedergibt, und Erfassen eines zweiten relationalen Ausdrucks, der eine Kapazitätsveränderung jeder Batteriezelle wiedergibt; und

Erhalten einer positiven Korrelation zwischen der entsprechenden relativen Batteriekapazität und relativen Selbstentladung jeder Batteriezelle und den Ladungszustandswerten der Referenzbatteriezelle, den Ladungszustandswerten jeder Batteriezelle und den Zeitstempeln zu den entsprechenden Zeitpunkten auf der Grundlage des ersten relationalen Ausdrucks und des zweiten relationalen Ausdrucks.

6. Batteriedetektionsverfahren nach Anspruch 5, **dadurch gekennzeichnet, dass** das Erhalten einer positiven Korrelation zwischen der entsprechenden relativen Batteriekapazität und relativen Selbstentladung jeder Batteriezelle und den Ladungszustandswerten der Referenzbatteriezelle, den Ladungszustandswerten jeder Batteriezelle und den Zeitstempeln zu den entsprechenden Zeitpunkten auf der Grundlage des ersten relationalen Ausdrucks und des zweiten relationalen Ausdrucks Folgendes umfasst:

Durchführen einer Parametertransformation auf dem ersten relationalen Ausdruck und dem zweiten relationalen Ausdruck unter einer Bedingung, dass der erste relationale Ausdruck gleich dem zweiten relationalen Ausdruck ist; und

Erhalten einer positiven Korrelation zwischen der entsprechenden relativen Batteriekapazität und relativen Selbstentladung jeder Batteriezelle und den Ladungszustandswerten der Referenzbatteriezelle, den Ladungszustandswerten jeder Batteriezelle und den Zeitstempeln zu den entsprechenden Zeitpunkten auf der Grundlage eines Transformationsergebnisses.

7. Batteriedetektionsverfahren nach Anspruch 5, **dadurch gekennzeichnet, dass** das Erfassen eines ersten relationalen Ausdrucks, der eine Kapazitätsveränderung der Referenzbatteriezelle wiedergibt, und das Erfassen eines zweiten relationalen Ausdrucks, der eine Kapazitätsveränderung jeder Batteriezelle wiedergibt, Folgendes umfasst:

Erhalten eines ersten relationalen Ausdrucks, der eine Kapazitätsveränderung der Referenzbatteriezelle wiedergibt, auf der Grundlage einer Batteriekapazität der Referenzbatteriezelle, einer Ladungsveränderung der Referenzbatteriezelle, einer Selbstentladung der Referenzbatteriezelle und Zeitstempeln zu entsprechenden Zeitpunkten der Referenzbatteriezelle; und

Erhalten eines zweiten relationalen Ausdrucks, der eine Kapazitätsveränderung jeder Batteriezelle wiedergibt, auf der Grundlage der Batteriekapazität jeder Batteriezelle, einer Ladungsveränderung jeder Batteriezelle, einer Selbstentladung jeder Batteriezelle und einer Standzeit jeder Batteriezelle.

8. Batteriedetektionsverfahren nach Anspruch 3, **dadurch gekennzeichnet, dass** das Erhalten eines Konsistenzdetektionsergebnisses der Batteriezellen im Batteriesystem Folgendes umfasst:

Erhalten einer Veränderung der Batteriekapazität jeder Batteriezelle und der Batteriekapazität der Referenzbatteriezelle im Batteriesystem auf der Grundlage der entsprechenden relativen Batteriekapazität und relativen Selbstentladung jeder Batteriezelle; und

Erhalten eines Konsistenzdetektionsergebnisses der Batteriezellen im Batteriesystem auf der Grundlage der Veränderung.

9. Batteriedetektionsverfahren nach Anspruch 8, **dadurch gekennzeichnet, dass** das Erhalten einer Veränderung der Batteriekapazität jeder Batteriezelle und der Batteriekapazität der Referenzbatteriezelle im Batteriesystem auf der Grundlage der entsprechenden relativen Batteriekapazität und relativen Selbstentladung jeder Batteriezelle Folgendes umfasst:

Einsetzen eines Regressionsergebnisses, das der entsprechenden relativen Batteriekapazität und relativen Selbstentladung jeder Batteriezelle entspricht, in einen dritten relationalen Ausdruck, um eine Entsprechung zwischen den Ladungszustandswerten jeder Batteriezelle und den Ladungszustandswerten der Referenzbatteriezelle zu erhalten; und

Erhalten einer Veränderung der Batteriekapazität jeder Batteriezelle und der Batteriekapazität der Referenzbatteriezelle im Batteriesystem auf der Grundlage der Entsprechung.

10. Batteriedetektionsverfahren nach Anspruch 9, **dadurch gekennzeichnet, dass** das Erhalten einer Veränderung der Batteriekapazität jeder Batteriezelle und der Batteriekapazität der Referenzbatteriezelle im Batteriesystem auf der Grundlage der Entsprechung Folgendes umfasst:

unter einer Bedingung, dass die Ladungszustandswerte jeder Batteriezelle im Batteriesystem erste Ladungszustandswerte sind, Erhalten entsprechender erster Referenzladungszustandswerte der Referenzbatteriezelle auf der Grundlage der Entsprechung;

unter einer Bedingung, dass die Ladungszustandswerte jeder Batterie im Batteriesystem zweite Ladungszustandswerte sind, Erhalten entsprechender zweiter Referenzladungszustandswerte der Referenzbatteriezelle auf der Grundlage der Entsprechung, wobei der zweite Ladungszustandswert kleiner als der erste Ladungszustandswert ist; und

Verwenden eines Differenzwertes zwischen dem ersten Referenzladungszustandswert und dem zweiten Referenzladungszustandswert als eine Veränderung der Batteriekapazität jeder Batteriezelle und der Batteriekapazität der Referenzbatteriezelle.

11. Batteriedetektionsverfahren nach Anspruch 8, **dadurch gekennzeichnet, dass** das Batteriedetektionsverfahren ferner Folgendes umfasst:

Bereitstellen einer Warnung unter einer Bedingung, dass die entsprechende relative Batteriekapazität, relative Selbstentladung und Veränderung jeder Batteriezelle eine vorgegebene Warnungsbedingung erfüllen.

12. Batteriedetektionsverfahren nach Anspruch 11, **dadurch gekennzeichnet, dass** die vorgegebene Warnungsbedingung Folgendes umfasst:

die entsprechende relative Batteriekapazität jeder Batteriezelle ist kleiner als ein Schwellenwert der relativen Batteriekapazität; und/oder

eine Geschwindigkeit der Kapazitätsabnahme der entsprechenden relativen Batteriekapazität jeder Batteriezelle ist innerhalb einer Überwachungszeit der relativen Batteriekapazität größer als ein Abnahmegeschwindigkeits-Schwellenwert; und/oder

die entsprechende relative Selbstentladung jeder Batteriezelle ist größer als ein Schwellenwert der relativen Selbstentladung; und/oder

eine Zunahmegeschwindigkeit der Selbstentladung der entsprechenden relativen Selbstentladung jeder Batteriezelle ist innerhalb einer Überwachungszeit der relativen Selbstentladung größer als ein Zunahmegeschwindigkeits-Schwellenwert; und/oder

die Veränderung der Batteriekapazität jeder Batteriezelle und der Batteriekapazität der Referenzbatteriezelle im Batteriesystem ist größer als ein Veränderungsschwellenwert.

13. Batteriedetektionsvorrichtung, **dadurch gekennzeichnet, dass** die Batteriedetektionsvorrichtung Folgendes umfasst:

ein Erfassungsmodul (10), das konfiguriert ist, Ladungszustandswerte jeder Batteriezelle in einem Batteriesystem zu verschiedenen Zeitpunkten innerhalb einer vorgegebenen Zeitspanne zu erfassen;
ein Auswahlmodul (20), das konfiguriert ist, eine Referenzbatteriezelle aus den Batteriezellen auszuwählen; und
ein Regressionsanalysemodul (30), das konfiguriert ist, auf der Grundlage von Ladungszustandswerten der Referenzbatteriezelle, der Ladungszustandswerte jeder Batteriezelle und von Zeitstempeln zu entsprechenden Zeitpunkten eine multiple lineare Regressionsanalyse durchzuführen, um ein Konsistenzdetektionsergebnis der Batteriezellen im Batteriesystem zu erhalten.

14. Batteriedetektionseinrichtung, **dadurch gekennzeichnet, dass** die Batteriedetektionseinrichtung einen Speicher, einen Prozessor und ein Batteriedetektionsprogramm, das im Speicher gespeichert ist und auf dem Prozessor ablaufen kann, umfasst, wobei das Batteriedetektionsprogramm konfiguriert ist, das Batteriedetektionsverfahren nach einem der Ansprüche 1 bis 12 zu implementieren.

15. Speichermedium, **dadurch gekennzeichnet, dass** das Speichermedium ein Batteriedetektionsprogramm speichert, wobei dann, wenn das Batteriedetektionsprogramm durch einen Prozessor ausgeführt wird, das Batteriedetektionsverfahren nach einem der Ansprüche 1 bis 12 implementiert wird.


**Revendications**

1. Procédé de détection de batterie, **caractérisé en ce que** le procédé de détection de batterie comprend :

   le fait d'acquérir (S10) les valeurs d'état de charge de chaque cellule de batterie dans un système de batterie à différents moments dans un intervalle de temps prédéfini ;
   le fait de sélectionner (S20) une cellule de batterie de référence parmi les cellules de batterie ; et
   le fait d'effectuer une analyse de régression linéaire multiple (S30) sur la base des valeurs d'état de charge de la cellule de batterie de référence, des valeurs d'état de charge de chaque cellule de batterie et des horodatages aux moments correspondants afin d'obtenir un résultat de détection de cohérence des cellules de batterie dans le système de batterie.

2. Procédé de détection de batterie selon la revendication 1, **caractérisé en ce que** le fait d'effectuer une analyse de régression linéaire multiple (S30) sur la base des valeurs d'état de charge de la cellule de batterie de référence, des valeurs d'état de charge de chaque cellule de batterie et des horodatages aux moments correspondants afin d'obtenir un résultat de détection de cohérence des cellules de batterie dans le système de batterie comprend :

   le fait d'acquérir (S301) une première matrice établie sur la base des valeurs d'état de charge de la cellule de batterie de référence, et d'acquérir une deuxième matrice établie sur la base des valeurs d'état de charge de chaque cellule de batterie et des horodatages à des moments correspondants ;
   le fait d'effectuer des calculs de régression linéaire (S302) sur la base de la première matrice et de la deuxième matrice afin d'obtenir la capacité de batterie relative correspondante et l'auto-décharge relative de chaque cellule de batterie ; et
   le fait d'obtenir (S303) un résultat de détection de cohérence des cellules de batterie dans le système de batterie en fonction de la capacité de batterie relative correspondante et de l'auto-décharge relative de chaque cellule de batterie.

3. Procédé de détection de batterie selon la revendication 2, **caractérisé en ce que** le fait d'effectuer des calculs de régression linéaire (S302) sur la base de la première matrice et de la deuxième matrice afin d'obtenir la capacité de batterie relative correspondante et l'auto-décharge relative correspondante de chaque cellule de batterie comprend :

   le fait d'effectuer des calculs de régression linéaire sur la base de la première matrice et de la deuxième matrice afin d'obtenir un résultat de régression comprenant un premier coefficient de régression et un deuxième coefficient de régression ; et
   le fait d'utiliser le premier coefficient de régression en tant que capacité de batterie relative correspondante de chaque cellule de batterie et d'utiliser le deuxième coefficient de régression en tant qu'auto-décharge relative correspondante de chaque cellule de batterie sur la base du résultat de régression.

4. Procédé de détection de batterie selon la revendication 3, **caractérisé en ce que** le fait d'effectuer des calculs de régression linéaire sur la base de la première matrice et de la deuxième matrice pour obtenir un résultat de régression comprenant un premier coefficient de régression et un deuxième coefficient de régression comprend :

le fait d'établir un modèle de régression linéaire, le modèle de régression linéaire comprenant une correspondance entre un premier coefficient de régression, un deuxième coefficient de régression, les valeurs d'état de charge de la cellule de batterie de référence, les valeurs d'état de charge de chaque cellule de batterie et les horodatages aux moments correspondants ; et

le fait de substituer la première matrice et la deuxième matrice dans le modèle de régression linéaire pour un calcul linéaire afin d'obtenir le premier coefficient de régression et le deuxième coefficient de régression.

5. Procédé de détection de batterie selon l'une quelconque des revendications 1 à 4, **caractérisé en ce que** le procédé de détection de batterie comprend en outre :

le fait d'acquérir une première expression relationnelle reflétant une variation de capacité de la cellule de batterie de référence et d'acquérir une deuxième expression relationnelle reflétant une variation de capacité de chaque cellule de batterie ; et

le fait d'obtenir, sur la base de la première expression relationnelle et de la deuxième expression relationnelle, une corrélation positive entre la capacité de batterie relative correspondante de la batterie et l'auto-décharge relative de chaque cellule de batterie et les valeurs d'état de charge de la cellule de batterie de référence, les valeurs d'état de charge de chaque cellule de batterie et les horodatages aux moments correspondants.

6. Procédé de détection de batterie selon la revendication 5, **caractérisé en ce que** l'obtention, sur la base de la première expression relationnelle et de la deuxième expression relationnelle, d'une corrélation positive entre la capacité de batterie relative correspondante et l'auto-décharge relative de chaque cellule de batterie et les valeurs d'état de charge de la cellule de batterie de référence, les valeurs d'état de charge de chaque cellule de batterie et les horodatages aux moments correspondants, comprend :

le fait d'effectuer une transformation de paramètres sur la première expression relationnelle et la deuxième expression relationnelle, dans le cas où la première expression relationnelle est égale à la deuxième expression relationnelle ; et

le fait d'obtenir, sur la base d'un résultat de transformation, une corrélation positive entre la capacité de batterie relative correspondante et l'auto-décharge relative de chaque cellule de batterie et les valeurs d'état de charge de la cellule de batterie de référence, les valeurs d'état de charge de chaque cellule de batterie et les horodatages aux moments correspondants.

7. Procédé de détection de batterie selon la revendication 5, **caractérisé en ce que** l'acquisition d'une première expression relationnelle reflétant une variation de capacité de la cellule de batterie de référence et l'acquisition d'une deuxième expression relationnelle reflétant une variation de capacité de chaque cellule de batterie comprennent :

le fait d'obtenir, sur la base d'une capacité de la cellule de batterie de référence, une variation de charge de la cellule de batterie de référence, l'auto-décharge de la cellule de batterie de référence et des horodatages à des moments correspondants de la cellule de batterie de référence, une première expression relationnelle reflétant une variation de capacité de la cellule de batterie de référence ; et

le fait d'obtenir, sur la base de la capacité de chaque cellule de batterie, une variation de charge de chaque cellule de batterie, une auto-décharge de chaque cellule de batterie et un temps d'immobilisation de chaque cellule de batterie, une deuxième expression relationnelle reflétant une variation de capacité de chaque cellule de batterie.

8. Procédé de détection de batterie selon la revendication 3, **caractérisé en ce que** l'obtention d'un résultat de détection de cohérence des cellules de batterie dans le système de batterie comprend :

le fait d'obtenir, sur la base de la capacité de batterie relative correspondante et de l'auto-décharge relative de chaque cellule de batterie, une variation de la capacité de batterie de chaque cellule de batterie et de la capacité de batterie de la cellule de batterie de référence dans le système de batterie ; et

le fait d'obtenir un résultat de détection de cohérence des cellules de batterie dans le système de batterie en fonction de la variation.

9. Procédé de détection de batterie selon la revendication 8, **caractérisé en ce que** l'obtention, sur la base de la capacité de batterie relative correspondante et de l'auto-décharge relative de chaque cellule de batterie, d'une variation de la capacité de batterie de chaque cellule de batterie et de la capacité de batterie de la cellule de batterie de référence dans le système de batterie comprend :

le fait de substituer un résultat de régression correspondant à la capacité de batterie relative correspondante et à l'auto-décharge relative de chaque cellule de batterie dans une troisième expression relationnelle afin d'obtenir une correspondance entre les valeurs d'état de charge de chaque cellule de batterie et les valeurs d'état de charge de la cellule de batterie de référence ; et

le fait d'obtenir, sur la base de la correspondance, une variation de la capacité de batterie de chaque cellule de batterie et de la capacité de la cellule de batterie de référence dans le système de batterie.

10. Procédé de détection de batterie selon la revendication 9, **caractérisé en ce que** l'obtention, sur la base de la correspondance, d'une variation de la capacité de batterie de chaque cellule de batterie et de la capacité de batterie de la cellule de batterie de référence dans le système de batterie comprend :

dans le cas où les valeurs d'état de charge de chaque cellule de batterie dans le système de batterie sont des premières valeurs d'état de charge, le fait d'obtenir des premières valeurs d'état de charge de référence correspondantes de la cellule de batterie de référence sur la base de la correspondance ;

dans le cas où les valeurs d'état de charge de chaque cellule de batterie dans le système de batterie sont des deuxièmes valeurs d'état de charge, le fait d'obtenir des deuxièmes valeurs d'état de charge de référence correspondantes de la cellule de batterie de référence sur la base de la correspondance, la deuxième valeur d'état de charge étant inférieure à la première valeur d'état de charge ; et

le fait d'utiliser une valeur de différence entre la première valeur de référence d'état de charge et la deuxième valeur de référence d'état de charge en tant que variation de la capacité de batterie de chaque cellule de batterie et de la capacité de batterie de la cellule de batterie de référence.

11. Procédé de détection de batterie selon la revendication 8, **caractérisé en ce que** le procédé de détection de batterie comprend en outre :

le fait de fournir un avertissement dans le cas où la capacité de batterie relative correspondante, l'auto-décharge relative et la variation de chaque cellule de batterie satisfont une condition d'avertissement prédéfinie.

12. Procédé de détection de batterie selon la revendication 11, **caractérisé en ce que** la condition d'avertissement prédéfinie comprend au moins un parmi ce qui suit :

la capacité de batterie relative correspondante de chaque cellule de batterie est inférieure à un seuil de capacité relative de batterie ;

une vitesse de diminution de capacité de la capacité de batterie relative correspondante de chaque cellule de batterie est supérieure à un seuil de vitesse de diminution dans un temps de surveillance de la capacité relative de batterie ;

l'auto-décharge relative correspondante de chaque cellule de batterie est supérieure à un seuil d'auto-décharge relative ;

une vitesse d'augmentation d'auto-décharge de l'auto-décharge relative correspondante de chaque cellule de batterie est supérieure à un seuil de vitesse d'augmentation dans un temps de surveillance de l'auto-décharge relative ; et

la variation de la capacité de batterie de chaque cellule de batterie et de la capacité de batterie de la cellule de batterie de référence dans le système de batterie est supérieure à un seuil de variation.

13. Appareil de détection de batterie, **caractérisé en ce que** l'appareil de détection de batterie comprend :

un module d'acquisition (10), configuré pour acquérir les valeurs d'état de charge de chaque cellule de batterie dans un système de batterie, à différents moments dans un temps prédéfini ;

un module de sélection (20), configuré pour sélectionner une cellule de batterie de référence parmi les cellules de batterie ; et

un module d'analyse de régression (30), configuré pour effectuer une analyse de régression linéaire multiple sur la base des valeurs d'état de charge de la cellule de batterie de référence, des valeurs d'état de charge de chaque cellule de batterie et des horodatages aux moments correspondants afin d'obtenir un résultat de détection de cohérence des cellules de batterie dans le système de batterie.

14. Dispositif de détection de batterie, **caractérisé en ce que** le dispositif de détection de batterie comprend une mémoire, un processeur et un programme de détection de batterie stocké dans la mémoire et apte à fonctionner sur le processeur, le programme de détection de batterie étant configuré pour mettre en œuvre le procédé de détection de batterie selon l'une quelconque des revendications 1 à 12.

**15.** Support de stockage, **caractérisé en ce que** le support de stockage stocke un programme de détection de batterie, dans lequel, lorsque le programme de détection de batterie est exécuté par un processeur, le procédé de détection de batterie selon l'une quelconque des revendications 1 à 12 est mis en œuvre.

Acquire state of charge values of each battery cell in a battery system at different time points within a preset time —S10

Select a reference battery cell from the battery cells —S20

Perform multiple linear regression analysis based on state of charge values of the reference battery cell, the state of charge values of each battery cell, and times at corresponding time points to obtain a consistency detection result of the battery cells in the battery system — S30

FIG. 1

Acquire a first matrix established based on state of charge values of a reference battery cell, and acquire a second matrix established based on state of charge values of each battery cell and times at corresponding time points — S301

Perform linear regression calculation based on the first matrix and the second matrix to obtain corresponding relative battery capacity and relative self-discharge of each battery cell — S302

Obtain a consistency detection result of the battery cells in the battery system based on the corresponding relative battery capacity and relative self-discharge of each battery cell — S303

FIG. 2

```
┌─────────────────────────────────┐
│ Read data such as current, voltage, │
│   and temperature of a battery      │
└─────────────────────────────────┘
                 │
                 ▼
┌─────────────────────────────────┐
│  Filter the data satisfying an OCV  │
│  condition, and look up a table to  │
│         obtain an SOC               │
└─────────────────────────────────┘
                 │
                 ▼
┌─────────────────────────────────┐
│  Select OCV data within a certain   │
│   time window for regression        │
│          calculation                │
└─────────────────────────────────┘
                 │
                 ▼
┌─────────────────────────────────┐
│ Perform result verification and filter │
│            output                   │
└─────────────────────────────────┘
```

FIG. 3

Battery cell detection apparatus

Acquiring module — 10

Selecting module — 20

Regression analysis module — 30

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 115808632 A